(19) **Europäisches Patentamt / European Patent Office / Office européen des brevets**

(11) **EP 3 751 744 B1**

(12) **FASCICULE DE BREVET EUROPEEN**

(45) Date de publication et mention de la délivrance du brevet:
**17.08.2022 Bulletin 2022/33**

(21) Numéro de dépôt: **20179337.9**

(22) Date de dépôt: **10.06.2020**

(51) Classification Internationale des Brevets (IPC):
**H03M 13/11** $^{(2006.01)}$ **H03M 13/35** $^{(2006.01)}$

(52) Classification Coopérative des Brevets (CPC):
**H03M 13/1148; H03M 13/116; H03M 13/356; H03M 13/611; H03M 13/6502**

(54) **CODAGE LDPC A PROTECTION DIFFERENCIEE**

LDPC-KODIERUNG MIT UNGLEICHEM FEHLERSCHUTZ

LDPC CODING WITH UNEQUAL ERROR PROTECTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.06.2019 FR 1906291**

(43) Date de publication de la demande:
**16.12.2020 Bulletin 2020/51**

(73) Titulaires:
- **THALES**
  **92400 Courbevoie (FR)**
- **Centre National d'Etudes Spatiales**
  **75001 Paris (FR)**
- **Centre National de la Recherche Scientifique**
  **75016 Paris (FR)**
- **Institut National Polytechnique de Toulouse**
  **31029 Toulouse Cedex 4 (FR)**
- **Tesa Telecom Spatiales Aeronautiques**
  **31500 Toulouse (FR)**

(72) Inventeurs:
- **ORTEGA ESPLUGA, Lorenzo**
  **31500 TOULOUSE (FR)**
- **POULLIAT, Charly**
  **31029 TOULOUSE CEDEX 4 (FR)**
- **AL BITAR, Hanaa**
  **31037 TOULOUSE (FR)**
- **BOUCHERET, Marie-Laure**
  **31029 TOULOUSE CEDEX 4 (FR)**
- **AUBAULT, Marion**
  **31401 TOULOUSE CEDEX 9 (FR)**

(74) Mandataire: **Marks & Clerk France**
**Immeuble "Visium"**
**22, avenue Aristide Briand**
**94117 Arcueil Cedex (FR)**

(56) Documents cités:
- **RAHNAVARD N ET AL: "NEW RESULTS ON UNEQUAL ERROR PROTECTION USING LDPC CODES", IEEE COMMUNICATIONS LETTERS, IEEE SERVICE CENTER, PISCATAWAY, NJ, US, vol. 10, no. 1, 1 janvier 2006 (2006-01-01), pages 43-45, XP001238634, ISSN: 1089-7798, DOI: 10.1109/LCOMM.2006.1576564**
- **RICCIUTELLI GIACOMO ET AL: "LDPC coded modulation schemes with largely unequal error protection", PROC. 2015 IEEE INTERNATIONAL BLACK SEA CONFERENCE ON COMMUNICATIONS AND NETWORKING (BLACKSEACOM), IEEE, 18 mai 2015 (2015-05-18), pages 48-52, XP033191574, DOI: 10.1109/BLACKSEACOM.2015.7185084**
- **CHI-JEN WU ET AL: "A new construction of UEP QC-LDPC codes", PROC. IEEE INTERNATIONAL SYMPOSIUM ON INFORMATION THEORY, ISIT 2010, IEEE, PISCATAWAY, NJ, USA, 13 juin 2010 (2010-06-13), pages 849-853, XP031710648, ISBN: 978-1-4244-7890-3**
- **KUMAR V ET AL: "On unequal error protection LDPC codes based on Plotkin-type constructions", PROC. IEEE GLOBAL TELECOMMUNICATIONS CONFERENCE 2004 (GLOBECOM '04), DALLAS, TX, USA 29 NOV.-3 DEC. 2004, PISCATAWAY, NJ, USA,IEEE, PISCATAWAY, NJ, USA, vol. 1, 29 novembre 2004 (2004-11-29), pages 493-497, XP010758937, ISBN: 978-0-7803-8794-2**

• JIA MINLI ET AL: "LDPC Coded Irregular Modulation Based on Degree Distribution", PROC. INTERNATIONAL CONFERENCE ON WIRELESS COMMUNICATIONS, NETWORKING AND MOBILE COMPUTING 2007, WICOM 2007, IEEE, PISCATAWAY, NJ, USA, 21 septembre 2007 (2007-09-21), pages 873-876, XP031261400, ISBN: 978-1-4244-1311-9

**Description**

L'invention concerne le domaine des télécommunications numériques et plus précisément le domaine du codage de canal qui vise l'utilisation de codes correcteurs dans le but d'augmenter le niveau de redondance de l'information transmise de sorte à pouvoir reconstruire le message initialement généré malgré les erreurs introduites lors de la transmission de ce message à travers un canal de propagation non parfait.

L'invention concerne plus particulièrement le domaine des codes correcteurs du type codes LDPC (Low Density Parity Codes) et porte sur un procédé de codage permettant d'appliquer une protection différenciée aux données à transmettre en fonction de niveaux de priorité différents. L'invention propose à cet effet une structure particulière de matrice de parité de code LDPC.

L'invention s'applique avantageusement aux standards de radionavigation par satellite ou standards GNSS (Global Navigation Satellite System) tels que les standards GPS ou Galileo.

Les standards GNSS définissent des messages GNSS qui sont transmis via des trames de données. De tels messages comprennent des données relatives à des informations de positionnement tels que des éphémérides satellites, des informations sur l'horloge du satellite, des données de service ou encore d'intégrité.

Dans les standards actuels, ces données sont protégées par un code correcteur simple qui est appliqué directement sur l'ensemble d'une trame de données. Cette méthode présente l'inconvénient de ne pas permettre une optimisation fine du compromis entre le débit consommé par l'ajout du code correcteur et le niveau de protection nécessaire.

En effet, les données transmises dans une trame GNSS sont de natures diverses et peuvent être classifiées en plusieurs groupes présentant des niveaux de priorité différents. Par niveau de priorité, on entend ici, un niveau de priorité sur la criticité des données à transmettre. Certaines données sont plus importantes que d'autres et nécessitent donc un niveau de protection par codage correcteur plus important pour assurer leur transmission correcte avec un niveau de fiabilité compatible du niveau de priorité. Par ailleurs, certaines données critiques nécessitent d'être transmises plus rapidement que d'autres.

L'invention peut s'appliquer de façon similaire à d'autres systèmes de transmission de données pour lesquels il est possible de regrouper les données en plusieurs ensembles ayant des niveaux de priorité différents.

Une méthode générale pour protéger des données numériques à transmettre comprenant plusieurs niveaux de priorité consiste à mettre en œuvre un codage différencié ou un codage à protection inégale. Cette méthode permet d'optimiser la protection des données et/ou le temps nécessaire pour les démoduler en fonction du niveau d'importance des données.

Classiquement, il existe deux manières de réaliser de la protection inégale des données avec un code correcteur d'erreurs.

Une première solution, par exemple décrite dans les références [1] et [2], consiste à construire des codes correcteurs spécifiques, dont la structure naturelle comporte différentes classes de protections.

Ces techniques sont en général applicables uniquement pour des tailles de trames importantes (de l'ordre de 4000 bits), ce qui n'est pas compatible des applications GNSS du fait de la latence imposée par ces tailles importantes. Par ailleurs, certaines méthodes, comme celle décrite dans la référence [2], proposent une structure du code qui repose sur l'hypothèse particulière de communications en relayage (ou coopératives) qui permettent de garantir des diversités d'évanouissements en réception. Ces hypothèses sont contraignantes et ne correspondent pas toujours au cas d'application visé.

Une autre méthode, décrite dans la référence [3], consiste à appliquer des rendements de codage différents en fonction des données que l'on cherche à transmettre au niveau applicatif. Cette technique, bien qu'efficace, comporte également plusieurs inconvénients. En premier lieu, cette méthode implique une signalisation importante (depuis la couche applicative) des différentes classes de bits qu'on cherche à protéger, ce qui entraine un surcout de signalisation inter-couche. Par ailleurs, cela signifie qu'on a plusieurs classes de débits d'un point de vue des couches inférieures, ce qui est difficile à gérer pour des applications de transmission par satellite.

Enfin, l'ensemble de ces techniques comporte un défaut commun. Elles induisent une différence de performances entre les bits les mieux protégés et les bits les moins protégés qui est souvent important. Cela signifie que les bits les moins importants sont très peu protégés ce qui n'est pas toujours souhaitable selon l'application visée.

La demande de brevet FR3035286 du Demandeur permet de répondre à cette problématique, mais en utilisant deux types de codes, un code interne et un code externe. Le code interne est appliqué aux bits de données qui sont estimés prioritaires par rapport aux autres.

On connait par ailleurs les solutions décrites dans les documents suivants :

- Rahnavard N et al : « New results on unequal error protection using LDPC codes", IEEE Communications letters,

- Ricciutelli Giacomo et al : « LDPC coded modulation schemes with largely unequal error protection »,

- Chi-Jen Wu et ak: « a new construction of UEP QC-LDPC codes",

- Kumar v et al: "On unequal error protection LDPC codes based on Plotkin-type constructions".

L'invention propose une nouvelle méthode de protection inégale aux erreurs qui est basée sur une structure de matrice de parité particulière pour des codes de type LDPC.

Un message encodé à partir de cette matrice permet de générer des données protégées selon deux niveaux de priorité. En réception, les données prioritaires peuvent être décodées avec une probabilité d'erreur plus faible mais aussi plus rapidement car il n'est pas nécessaire de recevoir l'intégralité de la trame codée pour pouvoir décoder les bits prioritaires.

L'invention a pour objet une méthode d'encodage telle que définie dans les revendications.

L'invention a aussi pour objet un dispositif d'encodage comprenant des moyens configurés pour exécuter la méthode d'encodage d'un message binaire selon l'invention.

L'invention a aussi pour objet un émetteur comprenant un dispositif d'encodage selon l'invention pour encoder un message binaire composé d'un premier sous-message ayant un premier niveau de priorité et d'un second sous-message ayant un second niveau de priorité afin de produire un message binaire codé composé de deux sous-messages codés indépendants comprenant chacun des bits d'information correspondants à une moitié du premier sous-message et à une moitié du second sous-message et des bits de parité, l'émetteur comprenant un moyen de transmission configuré pour transmettre indépendamment chacun des deux sous-messages codés.

L'invention a encore pour objet un programme d'ordinateur comportant des instructions pour l'exécution de la méthode d'encodage selon l'invention, lorsque le programme est exécuté par un processeur ainsi qu'un support d'enregistrement lisible par un processeur sur lequel est enregistré un programme comportant des instructions pour l'exécution de la méthode d'encodage selon l'invention, lorsque le programme est exécuté par un processeur.

D'autres caractéristiques et avantages de la présente invention apparaîtront mieux à la lecture de la description qui suit en relation aux dessins annexés suivants.

[Fig. 1] la figure 1 représente la structure d'une matrice de parité d'un code correcteur selon un mode de réalisation de l'invention,

[Fig. 2] la figure 2 représente la matrice de parité de la figure 1 sous une forme systématique,

[Fig. 3] la figure 3 représente la matrice de parité de la figure 2 avec des éléments de détails,

[Fig. 4] la figure 4 représente un exemple de structure d'un message codé à l'aide d'une méthode de codage selon l'invention,

[Fig. 5] la figure 5 représente un organigramme d'une méthode de codage selon l'invention,

[Fig. 6] la figure 6 représente un exemple de résultats de performances obtenus via la méthode de codage selon l'invention,

[Fig. 7] la figure 7 représente un synoptique d'un codeur à protection différenciée selon l'invention,

[Fig. 8] la figure 8 représente un synoptique d'un émetteur comprenant un codeur à protection différenciée selon l'invention.

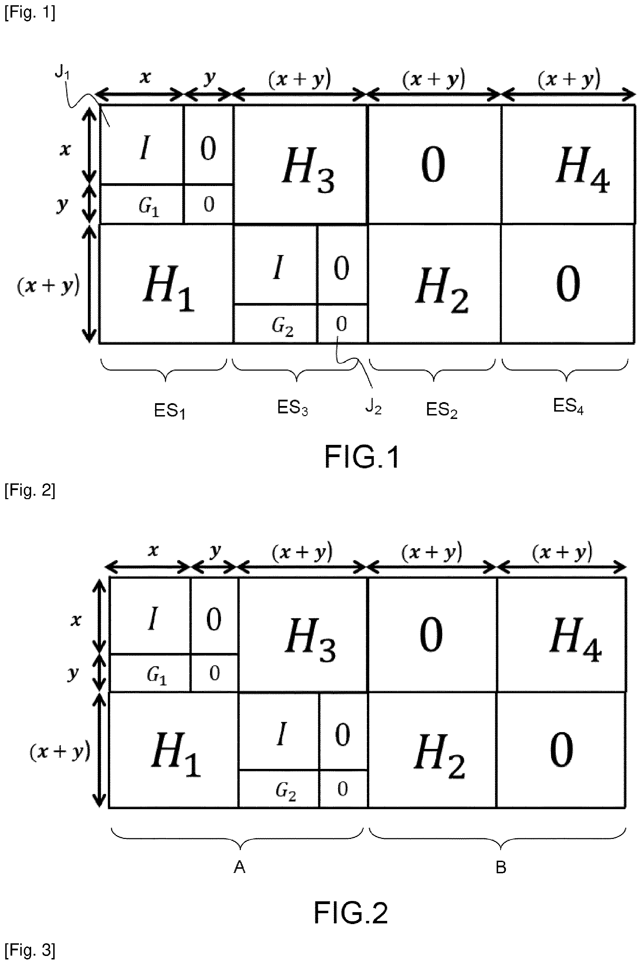

L'invention propose une nouvelle structure de matrice de parité $H$ d'un code correcteur LDPC. Cette nouvelle structure est représentée à la figure 1. Elle permet d'appliquer deux niveaux de protection différents aux données à transmettre.

La structure de la matrice $H$ est illustrée à la figure 1. Elle est composée de quatre ensembles $ES_1, ES_2, ES_3, ES_4$ composés chacun de deux sous-matrices concaténées selon la dimension verticale. Au total, la matrice $H$ est constituée de huit sous-matrices carrées de dimensions $(x+y ; x+y)$. $x$ et $y$ sont des valeurs entières qui définissent la proportion des bits de haute priorité et des bits de basse priorité dans le message à coder. Si on note $M$ le message binaire à coder, ce message est composé de $2x$ bits de haute priorité et de $2y$ bits de basse priorité.

Le premier ensemble $ES_1$ est composé de deux sous-matrices $J_1$ et $H_1$. Le deuxième ensemble $ES_2$ est composé de la matrice nulle et d'une sous-matrice $H_2$. Le troisième ensemble $ES_3$ est composé de deux sous-matrices $H_3$ et $J_2$. Le quatrième ensemble $ES_4$ est composé d'une sous-matrice $H_4$ et de la matrice nulle.

Les sous-matrices $J_1$ et $J_2$ sont de la forme ou avec $I$ la matrice identité de dimensions $(x,x)$ et $G_1, G_2$ une sous-matrice de dimensions $(x,y)$. Les autres coefficients des sous-matrices $J_1$ et $J_2$ sont nuls.

Les sous-matrices $H_1$, $H_2$, $H_3$, $H_4$, $G_1$, $G_2$ sont des matrices de faible densité qui sont générées par des techniques d'optimisation, par exemple une méthode du type « density evolution » ou « EXIT chart » décrite dans la référence [7].

La figure 2 représente la matrice de parité $H$

dans une autre forme selon laquelle les ensembles $ES_2$ et $ES_3$ sont permutés. De façon générale, les quatre ensembles de matrice peuvent être permutés selon n'importe quelle permutation sans modifier le principe du codage. La matrice de parité H est représentée sur la figure 2 sous sa forme systématique. C'est-à-dire que la sous-matrice A (composée des ensembles $ES_1$ et $ES_3$) correspond aux bits d'information tandis que la sous-matrice B (composée des ensembles $ES_2$ et $ES_4$) correspond aux bits de parité.

Si on note M le message binaire à coder, le vecteur des bits de parité P est obtenu à partir des relations suivantes :

[Math.1]

$$AM^T + BP^T = 0$$

[Math.2]

$$P^T = AB^{-1}M^T$$

La sous-matrice B doit être inversible et de rang maximum.

La figure 3 représente encore une autre illustration de la matrice de parité H. Chaque sous-matrice $H_1$, $H_2$, $H_3$, $H_4$ est composée de deux matrices carrées de dimensions respectives (x,x) et (y,y) et de deux matrices de dimensions respectives (x,y) et (y,x).

La matrice de parité H comporte 4(x+y) colonnes et 2(x+y) lignes.

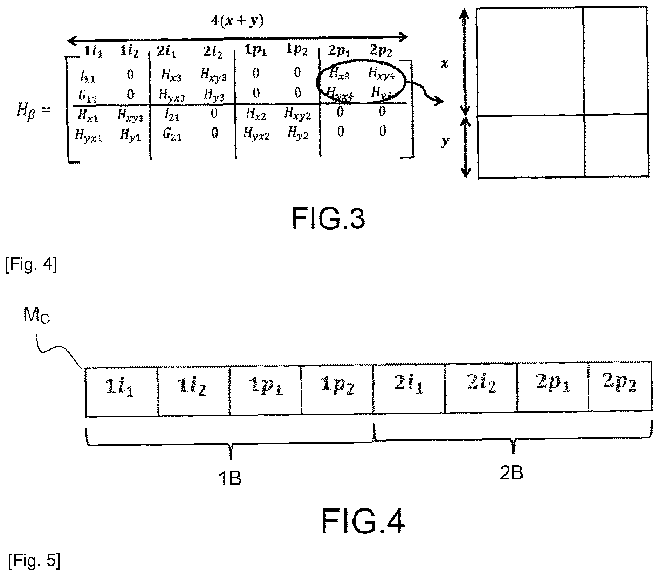

La figure 4 schématise la structure du message codé $M_c$ obtenu après codage du message M à partir de la matrice H. Le message codé $M_c$ est composé de deux trames ou deux blocs 1B et 2B distincts qui peuvent être transmis et décodés séparément et indépendamment.

Chaque bloc est composé :

- d'une première partie $1i_1$,$2i_1$ contenant une moitié respective des bits de haute priorité du message M,

- d'une deuxième partie $1i_2$,$2i_2$ contenant une moitié respective des bits de basse priorité du message M,

- d'une troisième partie $1p_1$,$2p_1$ contenant les bits de parité associés à la première partie,

- d'une quatrième partie $1p_2$,$2p_2$ contenant les bits de parité associés à la deuxième partie.

Sur la figure 3, les notations de la figure 4 sont reprises afin d'indiquer pour chaque ensemble, les bits du message codé correspondants.

Le taux de codage appliqué aux bits de haute priorité est supérieur au taux de codage appliqué aux bits de basse priorité.

Les blocs 1B et 2B peuvent être décodés indépendamment. Le décodage peut être réalisé en utilisant un algorithme de décodage adapté au décodage de code correcteur LDPC, par exemple un algorithme du type « Belief Propagation » tel que décrit dans la référence [7], ou tout autre algorithme équivalent.

L'invention présente plusieurs avantages du fait de la structure particulière de la matrice de parité proposée.

Dans le cas d'une transmission des blocs 1B et 2B sur un canal sans erreur, il est possible de récupérer tous les bits de haute priorité du message M à partir du décodage d'un seul des deux blocs. Cette propriété permet d'assurer une transmission plus fiable et plus rapide des bits de haute priorité.

Dans le cas d'une transmission sur un canal avec erreurs (canal radio par exemple), le décodage d'un seul des deux blocs 1B,2B permet de récupérer les bits de haute priorité avec une probabilité d'erreur inférieure à celle obtenue pour un code défini avec une matrice de parité adaptée à un seul niveau de priorité. Une telle matrice est définie par la structure de la figure 1 avec y=0. Elle correspond à un code dit « Root-LDPC » tel que décrit dans la référence [6].

La capacité de correction d'erreur associée aux bits de haute priorité est liée au ratio x/y.

Dans une variante de réalisation de l'invention, pour obtenir un système robuste, les capacités de correction d'erreur sont rendues équivalentes quel que soit le bloc 1B ou 2B décodé. Pour obtenir ce résultat, les sous-matrices $H_1$ et $H_3$ ont la même densité de « 1 ». De même, les sous-matrices $H_2$ et $H_4$ ont la même densité de « 1 ». Les sous-matrices $G_1$ et $G_2$ ont aussi la même densité de « 1 ».

Par exemple, les sous-matrices $H_1$, $H_2$, $H_3$, $H_4$ sont des matrices de parité quasi-cycliques telles que définies dans [7].

La figure 5 schématise un organigramme d'un exemple de procédé de codage selon l'invention. Un message binaire M est reçu puis une étape 501 de séparation des bits du message en fonction de leurs niveaux de priorité est appliquée. Ensuite, une étape de codage 502 est appliqué aux bits organisés selon leurs niveaux de priorité pour générer le message codé $M_c$ qui est composé des deux blocs 1B et 2B. L'étape de codage 502 est réalisée à partir de la matrice de parité H selon l'invention.

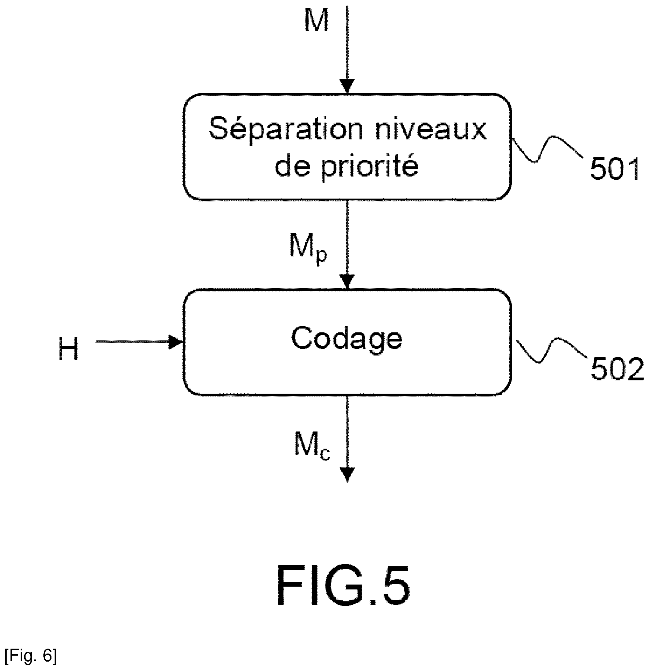

La figure 6 représente, sur un diagramme, des exemples de résultats obtenus à l'aide de la méthode de codage selon l'invention. Pour cet exemple particulier, les sous matrices $H_1$, $H_2$, $H_3$, $H_4$ sont des sous-matrices de parité quasi-cycliques ayant une densité égale à 3. Les sous-matrices $G_1$ et $G_2$ ont une densité égale à 2.

Les courbes représentées sur la figure 6 sont des courbes de taux d'erreurs binaires en fonction du rapport de la puissance de la porteuse sur la densité spectrale du bruit t $C/N_0$.

La courbe 501 est une courbe de probabilité d'erreurs sur tous les bits d'information décodés correspondent au code LDPC utilisé dans la composante des données du signal de navigation GPS L1C tel qu'explicité dans la référence [8].

Les courbes 502,503,504 et 505 sont des probabilité d'erreurs sur tous les bits d'information décodés lorsque les deux blocs 1B et 2B sont reçus et décodés.

La courbe 502 correspond au cas y=0, c'est-à-dire un codage avec un seul niveau de priorité. Les courbes 503,504 et 505 correspondent respectivement à des valeurs de x égales à 200,100 et 50 pour une valeur de x+y= 250 pour tous les cas. Le code correcteur de base est de rendement ½.

Les courbes 510,520,530,540 correspondent à la probabilité d'erreur sur les bits de haute priorité lorsque seulement un des deux blocs 1B ou 2B est reçu et décodé. Les courbes en pointillés correspondent au premier bloc 1B et les courbes avec des symboles correspondent au second bloc 2B. Les courbes se superposent.

Les courbes 540 correspondent au cas y=0. Les courbes 510,520,530 correspondent respectivement à des valeurs de x égales à 200,100 et 50 pour une valeur de x+y= 250 pour tous les cas.

La proportion de bits de haute priorité a une influence sur la probabilité d'erreur des bits de haute priorité, plus cette proportion est élevée, plus la probabilité d'erreur est faible.

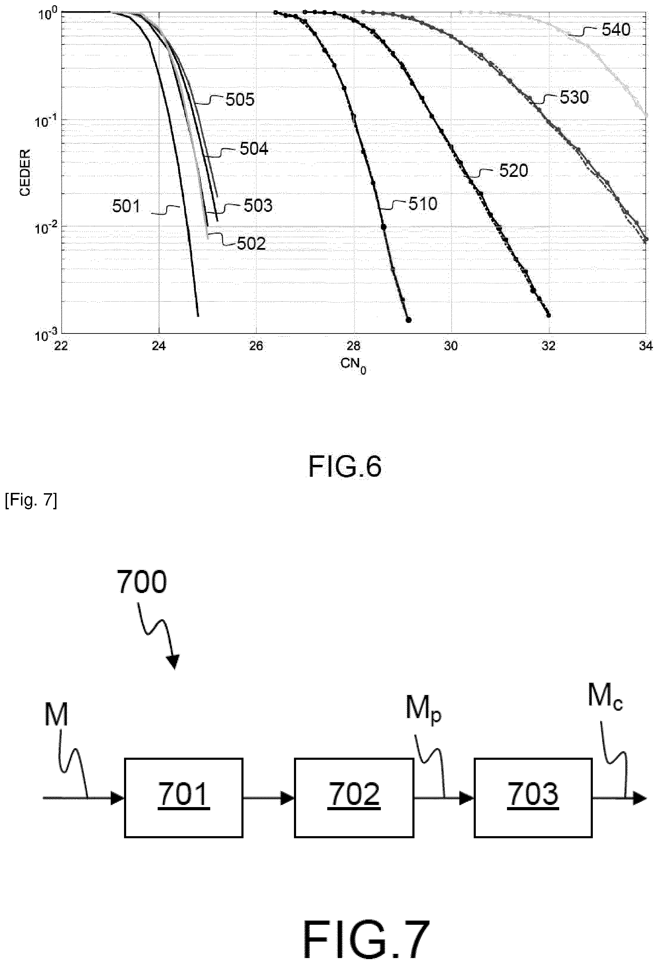

La figure 7 représente schématiquement un synoptique d'un codeur à protection différenciée selon l'invention, apte à mettre en œuvre le procédé de codage décrit à la figure 5.

Le codeur 700 selon l'invention reçoit en entrée un message binaire M à coder et produit en sortie un message binaire codé $M_c$ composé de deux blocs 1B et 2B. Le codeur 700 comprend un premier module 701 d'affectation d'un niveau de priorité aux bits du message M, un deuxième module 702 pour regrouper les bits de mêmes niveau de priorité ensemble et organiser le message avant codage selon la structure attendue. Le codeur 700 comporte en outre un troisième module 703 de codage pour coder le message binaire à partir de la matrice de parité H.

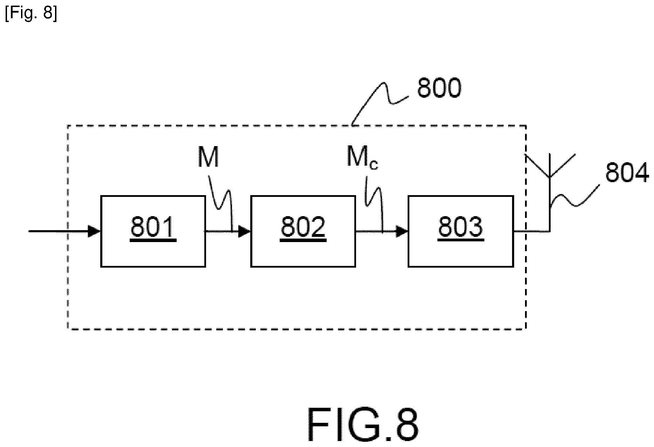

La figure 8 représente un synoptique d'un émetteur 800 comprenant un codeur 802 selon l'invention. L'émetteur 800 peut comporter en outre un module applicatif 801 pour générer des trames de bits M et un module radio 803 pour moduler, filtrer, mettre en forme et convertir analogiquement une trame de bits codée $M_c$ avant sa transmission à une antenne 804 pour être émise sur un canal radio. L'émetteur 800 peut, par exemple, être un émetteur compatible d'un système de radio-navigation par satellite. A ce titre, l'émetteur 800 peut être embarqué dans la charge utile d'un satellite.

Les modules du codeur et du décodeur selon l'invention peuvent être implémentés à partir d'éléments matériel et/ou logiciel. A ce titre, l'invention peut notamment être mise en œuvre en tant que programme d'ordinateur comportant des instructions pour son exécution. Le programme d'ordinateur peut être enregistré sur un support d'enregistrement lisible par un processeur. Le support peut être électronique, magnétique, optique ou électromagnétique.

En particulier, l'invention dans son ensemble ou chaque module du codeur ou du décodeur selon l'invention peut être implémenté par un dispositif comprenant un processeur et une mémoire. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gate Array »).

Le dispositif peut utiliser un ou plusieurs circuits électroniques dédiés ou un circuit à usage général. La technique de l'invention peut se réaliser sur une machine de calcul reprogrammable (un processeur ou un microcontrôleur par exemple) exécutant un programme comprenant une séquence d'instructions, ou sur une machine de calcul dédiée (par exemple un ensemble de portes logiques comme un FPGA ou un ASIC, ou tout autre module matériel).

Selon un mode de réalisation, le dispositif comprend au moins un support de stockage lisible par ordinateur (RAM, ROM, EEPROM, mémoire flash ou une autre technologie de mémoire, CD-ROM, DVD ou un autre support à disque optique, cassette magnétique, bande magnétique, disque de stockage magnétique ou un autre dispositif de stockage, ou un autre support de stockage non transitoire lisible par ordinateur) codé avec un programme d'ordinateur (c'est-à-dire plusieurs instructions exécutables) qui, lorsqu'il est exécuté sur un processeur ou plusieurs processeurs, effectue les fonctions des modes de réalisation de l'invention décrits précédemment.

A titre d'exemple d'architecture matérielle adaptée à mettre en œuvre l'invention, un dispositif selon l'invention peut comporter un bus de communication auquel sont reliés une unité centrale de traitement ou microprocesseur (CPU, acronyme de « *Central Processing Unit»* en anglais), une mémoire morte (ROM, acronyme de « *Read Only Memory* » en anglais) pouvant comporter les programmes nécessaires à la mise en œuvre de l'invention; une mémoire vive ou mémoire cache (RAM, acronyme de « *Random Access Memory* » en anglais) comportant des registres adaptés à enregistrer des variables et paramètres créés et modifiés au cours de l'exécution des programmes précités ; et une interface de communication ou E/S (I/O acronyme de « *Input/ouput* » en anglais) adaptée à transmettre et à recevoir des données.

La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en œuvre des aspects des techniques décrites ici. Les moyens ou ressources informatiques peuvent notamment être distribués (*"Cloud computing"*), éventuellement avec selon des technologies de pair-à-pair. Le code logiciel peut être exécuté sur n'importe quel processeur approprié (par exemple, un microprocesseur) ou cœur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en œuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

Références

[1] C. Poulliat, D. Declercq and I. Fijalkow, "Enhancement of Unequal Error Protection Properties of LDPC Codes", EURASIP Journal on Wireless Communications and Networking, vol. 2007, Article ID 92659, 9 pages, 2007.

[2] P. Pulini et al, "Unequal Diversity LDPC Codes for Relay Channels", IEEE Trans. On Wireless Communications, Vol 12, N° 11, November 2013.

[3] C. Lamy-Bergot & B. Gadat, "Embedding protection inside H.264/AVC and SVC streams", EURASIP Journal on Wireless Communications and Networking, 2010.

[4] C. Poulliat, "Contribution à l'étude et à l'optimisation de systèmes à composantes itératives",HdR 2011.

[5] FR3035286

[6] J. J. Boutros, A. Guillen i Fabregas, E. Biglieri and G. Zemor, "Low-Density Parity-Check Codes for Nonergodic Block-Fading Channels," in IEEE Transactions on Information Theory, vol. 56, no. 9, pp. 4286-4300, Sept. 2010.

[7] Ryan, W., Lin, S. (2009). Channel Codes: Classical and Modem. Cambridge: Cambridge University Press.

[8] Marion Roudier. Analysis and Improvement of GNSS Navigation Message Demodulation Performance in Urban Environments . Theses, INP Toulouse, January 2015.

## Revendications

1. Méthode d'encodage d'un message binaire (M) composé d'un premier sous-message ayant un premier niveau de priorité et d'un second sous-message ayant un second niveau de priorité, à partir d'un code de type LDPC défini par une matrice de parité H ayant une première dimension correspondant aux bits du message binaire codé ($M_c$) et une seconde dimension, la matrice de parité H étant constituée de quatre sous-ensembles ($ES_1,ES_2,ES_3,ES_4$) de deux sous-matrices concaténées selon la seconde dimension, les quatre sous-ensembles ($ES_1,ES_2,ES_3,ES_4$) étant concaténés selon la première dimension, la première sous-matrice ($J_1$) du premier sous-ensemble ($ES_1$) étant de la forme où x est égal à la taille de la moitié du premier sous-message, y est égal à la taille de la moitié du second sous-message, I est une matrice identité de dimensions (x,x) et $G_1$ est une matrice non nulle de dimensions (x,y), la seconde sous-matrice ($H_1$) du premier sous-ensemble ($ES_1$) étant une matrice non nulle, la première sous-matrice du deuxième sous-ensemble ($ES_2$) étant nulle, la seconde sous-matrice ($H_2$) du deuxième sous-ensemble ($ES_1$) étant une matrice non nulle, la première sous-matrice ($H_3$) du troisième sous-ensemble ($ES_3$) étant une matrice non nulle, la seconde sous-matrice ($J_2$) du troisième sous-ensemble ($ES_3$) étant de la forme

où $G_2$ est une matrice non nulle de dimensions (x,y), la première sous-matrice ($H_4$) du quatrième sous-ensemble ($ES_4$) étant une matrice non nulle, et la seconde sous-matrice du quatrième sous-ensemble ($ES_4$) étant nulle, les sous-matrices ($H_1$, $H_2$, $H_3$, $H_4$, $J_1$, $J_2$) des quatre sous-ensembles étant carrées de dimensions (x+y,x+y), la méthode d'encodage comprenant une étape (502) d'encoder le message binaire (M) à l'aide de la matrice de parité H pour produire le message binaire codé ($M_c$).

2. Méthode d'encodage d'un message binaire selon la revendication 1 dans lequel le message binaire codé ($M_c$) est composé de deux sous-messages (1B,2B) codés indépendants comprenant chacun des bits d'information correspondant à une moitié du premier sous-message et à une moitié du second sous-message et des bits de parité.

3. Méthode d'encodage d'un message binaire selon l'une des revendications précédentes dans lequel le premier sous-ensemble ($ES_1$) est associé à un premier ensemble de bits d'information constitué d'une première moitié du premier sous-message et d'une première moitié du second sous-message, le second sous-ensemble ($ES_2$) est associé aux bits de parité correspondants au premier ensemble de bits d'information, le troisième sous-ensemble ($ES_3$) est associé à un second ensemble de bits d'information constitué d'une seconde moitié du premier sous-message et d'une seconde moitié du second sous-message et le quatrième sous-ensemble ($ES_4$) est associé aux bits de parité correspondants au second ensemble de bits d'information.

4. Méthode d'encodage d'un message binaire selon l'une des revendications précédentes dans lequel la seconde sous-matrice ($H_2$) du deuxième sous-ensemble ($ES_2$) et la première sous-matrice ($H_4$) du quatrième sous-ensemble ($ES_4$) sont de rang maximum.

5. Méthode d'encodage selon l'une des revendications précédentes dans lequel :

    - la seconde sous-matrice ($H_1$) du premier sous-ensemble ($ES_1$) et la première sous-matrice ($H_3$) du troisième sous-ensemble ($ES_3$) ont la même densité de valeurs à « 1 »,
    - la seconde sous-matrice ($H_2$) du deuxième sous-ensemble ($ES_2$) et la première sous-matrice ($H_4$) du quatrième sous-ensemble ($ES_4$) ont la même densité de valeurs à « 1 »,
    - les sous-matrices $G_1$ et $G_2$ ont la même densité de valeurs à « 1 ».

6. Dispositif d'encodage (700) comprenant un codeur (703) configuré pour exécuter la méthode d'encodage d'un message binaire selon l'une des revendications précédentes.

7. Emetteur (800) comprenant un dispositif d'encodage (802) selon la revendication 6 pour encoder un message binaire composé du premier sous-message ayant un premier niveau de priorité et du second sous-message ayant un second niveau de priorité afin de produire un message binaire codé composé de deux sous-messages codés indépendants comprenant chacun des bits d'information correspondants à la moitié du premier sous-message et à la moitié du second sous-message et des bits de parité, l'émetteur comprenant un moyen de transmission (803) configuré pour transmettre indépendamment chacun des deux sous-messages codés.

8. Programme d'ordinateur comportant des instructions pour l'exécution de la méthode d'encodage selon l'une quelconque des revendications 1 à 5, lorsque le programme est exécuté par un processeur.

9. Support d'enregistrement lisible par un processeur sur lequel est enregistré un programme comportant des instructions pour l'exécution de la méthode d'encodage selon l'une quelconque des revendications 1 à 5, lorsque le programme est exécuté par un processeur.

**Patentansprüche**

1. Verfahren zum Codieren einer binären Nachricht (M), die aus einer ersten Unternachricht mit einer ersten Dringlichkeitsstufe und einer zweiten Unternachricht mit einer zweiten Dringlichkeitsstufe zusammengesetzt ist, unter Verwendung eines LDPC-Codes, der durch eine Paritätsmatrix H mit einer ersten Dimension, die den Bits der codierten binären Nachricht ($M_c$) entspricht, und einer zweiten Dimension definiert ist, wobei die Paritätsmatrix H aus vier Untergruppen ($ES_1$, $ES_2$, $ES_3$, $ES_4$) von zwei Untermatrizen besteht, die gemäß der zweiten Dimension verkettet sind, wobei die vier Untergruppen ($ES_1$, $ES_2$, $ES_3$, $ES_4$) gemäß der ersten Dimension verkettet sind, wobei die erste Untermatrix ($J_1$) der ersten Untergruppe ($ES_1$) folgende Form hat

worin x gleich der Größe der Hälfte der ersten Unternachricht ist, y gleich der Größe der Hälfte der zweiten Unternachricht ist, I eine Identitätsmatrix mit den Dimensionen (x,x) ist und $G_1$ eine Matrix ungleich Null mit den Dimensionen (x,y) ist, wobei die zweite Untermatrix ($H_1$) der ersten Untergruppe ($ES_1$) eine Matrix ungleich Null ist, wobei die erste Untermatrix der zweiten Untergruppe ($ES_2$) Null ist, wobei die zweite Untermatrix ($H_2$) der zweiten Untergruppe ($ES_1$) eine Matrix ungleich Null ist, die erste Untermatrix ($H_3$) der dritten Untergruppe ($ES_3$) eine Matrix ungleich Null ist, die zweite Untermatrix ($J_2$) der dritten Untergruppe ($ES_3$) folgende Form hat

worin $G_2$ eine Matrix ungleich Null mit den Dimensionen (x, y) ist, wobei die erste Untermatrix ($H_4$) der vierten Untergruppe ($ES_4$) eine Matrix ungleich Null ist und die zweite Untermatrix der vierten Untergruppe ($ES_4$) Null ist, wobei die Untermatrizen ($H_1$, $H_2$, $H_3$, $H_4$, $J_1$, $J_2$) der vier Untergruppen Quadrate mit den Dimensionenen (x+y,x+y) sind, wobei das Codierverfahren einen Schritt (502) zum Codieren der binären Nachricht (M) mit Hilfe der Paritätsmatrix H zum Erzeugen der codierten binären Nachricht ($M_c$) umfasst.

2. Verfahren zum Codieren einer binären Nachricht nach Anspruch 1, wobei die codierte binäre Nachricht ($M_c$) aus zwei unabhängig voneinander codierten Unternachrichten (1B, 2B) zusammengesetzt ist, die jeweils Datenbits umfassen, die einer Hälfte der ersten Unternachricht und einer Hälfte der zweiten Unternachricht und der Paritätsbits entsprechen.

3. Verfahren zum Codieren einer binären Nachricht nach einem der vorhergehenden Ansprüchen, wobei die erste Untergruppe ($ES_1$) einer ersten Datenbitgruppe zugeordnet ist, die aus einer ersten Hälfte der ersten Unternachricht und einer ersten Hälfte der zweiten Unternachricht besteht, die zweite Untergruppe ($ES_2$) den Paritätsbits zugeordnet ist, die der ersten Datenbitgruppe entsprechen, die dritte Untergruppe ($ES_3$) einer zweiten Datenbitgruppe zugeordnet ist, die aus einer zweiten Hälfte der ersten Unternachricht und einer zweiten Hälfte der zweiten Unternachricht besteht, und die vierte Untergruppe ($ES_4$) den Paritätsbits zugeordnet ist, die der zweiten Datenbitgruppe entsprechen.

4. Verfahren zum Codieren einer binären Nachricht nach einem der vorhergehenden Ansprüche, wobei die zweite Untermatrix ($H_2$) der zweiten Untergruppe ($ES_2$) und die erste Untermatrix ($H_4$) der vierten Untergruppe ($ES_4$) einen maximalen Rang haben.

5. Codierverfahren nach einem der vorhergehenden Ansprüche, wobei:

   - die zweite Untermatrix ($H_1$) der ersten Untergruppe ($ES_1$) und die erste Untermatrix ($H_3$) der dritten Untergruppe ($ES_3$) die gleiche Dichte von Werten "1" aufweisen,
   - die zweite Untermatrix ($H_2$) der zweiten Untergruppe ($ES_2$) und die erste Untermatrix ($H_4$) der vierten Untergruppe ($ES_4$) die gleiche Dichte von Werten "1" aufweisen,
   - die Untermatrizen $G_1$ und $G_2$ die gleiche Dichte von Werten "1" aufweisen.

6. Codiervorrichtung (700), umfassend einen Codierer (703), der dafür konfiguriert ist, das Verfahren zum Codieren einer binären Nachricht nach einem der vorhergehenden Ansprüche auszuführen.

7. Sender (800), umfassend eine Codiervorrichtung (802) nach Anspruch 6 zum Codieren einer binären Nachricht, die aus der ersten Unternachricht mit einer ersten Dringlichkeitsstufe und der zweiten Unternachricht mit einer zweiten Dringlichkeitsstufe zusammengesetzt ist, um eine codierte binäre Nachricht zu erzeugen, die aus zwei unabhängig voneinander codierten Unternachrichten zusammengesetzt ist, die jeweils Datenbits umfassen, die der Hälfte der ersten Unternachricht und der Hälfte der zweiten Unternachricht und der Paritätsbits entsprechen, wobei der Sender Übertragungsmittel (803) umfasst, die dafür konfiguriert sind, unabhängig voneinander jede der zwei codierten Unternachrichten zu übertragen.

8. Computerprogramm, umfassend Anweisungen zum Ausführen des Codierverfahrens nach einem der Ansprüche 1 bis 5, wenn das Programm von einem Prozessor ausgeführt wird.

9. Speichermedium, das von einem Prozessor lesbar ist, auf dem ein Programm gespeichert ist, das Anweisungen zum Ausführen des Codierverfahrens nach einem der Ansprüche 1 bis 5 umfasst, wenn das Programm von einem Prozessor ausgeführt wird.

**Claims**

1. A method for encoding a binary message (M) composed of a first sub-message having a first priority level and of a second sub-message having a second priority level, using an LDPC code defined by a parity matrix H having a first dimension corresponding to the bits of the coded binary message ($M_c$) and a second dimension, the parity-check matrix H consisting of four sub-sets ($ES_1$, $ES_2$, $ES_3$, $ES_4$) of two sub-matrices that are concatenated along the second dimension, the four sub-sets ($ES_1$, $ES_2$, $ES_3$, $ES_4$) being concatenated along the first dimension, the first sub-matrix ($J_1$) of the first sub-set ($ES_1$) taking the form

where x is equal to the size of half of the first sub-message, y is equal to the size of half of the second sub-message, I is an identity matrix of dimensions (x,x) and $G_1$ is a nonzero matrix of dimensions (x,y), the second sub-matrix ($H_1$) of the first sub-set ($ES_1$) being a nonzero matrix, the first sub-matrix of the second sub-set ($ES_2$) being a zero matrix, the second sub-matrix ($H_2$) of the second sub-set ($ES_1$) being a nonzero matrix, the first sub-matrix ($H_3$) of the third sub-set ($ES_3$) being a nonzero matrix, the second sub-matrix ($J_2$) of the third sub-set ($ES_3$) taking the form

where $G_2$ is a nonzero matrix of dimensions (x,y), the first sub-matrix ($H_4$) of the fourth sub-set ($ES_4$) being a nonzero matrix, and the second sub-matrix of the fourth sub-set ($ES_4$) being a zero matrix, the sub-matrices ($H_1$, $H_2$, $H_3$, $H_4$, $J_1$, $J_2$) of the four sub-sets being square and of dimensions (x+y,x+y), the encoding method comprising a step (502) of encoding the binary message (M) using the parity matrix H to produce the coded binary message ($M_c$).

2. The method for encoding a binary message according to claim 1, wherein the coded binary message ($M_c$) is composed of two independent coded sub-messages (1B, 2B) each comprising data bits corresponding to one half of the first sub-message and to one half of the second sub-message and of the parity bits.

3. The method for encoding a binary message according to one of the preceding claims, wherein the first sub-set ($ES_1$) is associated with a first data-bit set consisting of a first half of the first sub-message and of a first half of the second sub-message, the second sub-set ($ES_2$) is associated with the parity bits corresponding to the first data-bit set, the third sub-set ($ES_3$) is associated with a second data-bit set consisting of a second half of the first sub-message and of a second half of the second sub-message and the fourth sub-set ($ES_4$) is associated with the parity bits corresponding to the second data-bit set.

4. The method for encoding a binary message according to one of the preceding claims, wherein the second sub-matrix ($H_2$) of the second sub-set ($ES_2$) and the first sub-matrix ($H_4$) of the fourth sub-set ($ES_4$) are of maximum rank.

5. The encoding method according to one of the preceding claims, wherein:

   - the second sub-matrix ($H_1$) of the first sub-set ($ES_1$) and the first sub-matrix ($H_3$) of the third sub-set ($ES_3$) have the same density of "1" values,
   - the second sub-matrix ($H_2$) of the second sub-set ($ES_2$) and the first sub-matrix ($H_4$) of the fourth sub-set ($ES_4$) have the same density of "1" values,
   - the sub-matrices $G_1$ and $G_2$ have the same density of "1" values.

6. An encoding device (700) comprising a coder (703) configured to execute the method for encoding a binary message according to one of the preceding claims.

7. A transmitter (800) comprising an encoding device (802) according to claim 6 for encoding a binary message composed of the first sub-message having a first priority level and of the second sub-message having a second priority level, in order to produce a coded binary message composed of two independent coded sub-messages each comprising data bits corresponding to half of the first sub-message and half of the second sub-message and of the parity bits, the transmitter comprising a transmitting means (803) configured to transmit each of the two coded sub-messages independently.

8. A computer program containing instructions for executing the encoding method according to any one of claims 1 to 5, when the program is executed by a processor.

9. A processor-readable storage medium on which is stored a program containing instructions for executing the encoding method according to any one of claims 1 to 5, when the program is executed by a processor.

[Fig. 1]

FIG.1

[Fig. 2]

FIG.2

[Fig. 3]

$$
H_\beta = \begin{array}{c} \\ \\ \\ \\ \end{array}
\begin{array}{cc|cc|cc|cc}
1i_1 & 1i_2 & 2i_1 & 2i_2 & 1p_1 & 1p_2 & 2p_1 & 2p_2 \\
\hline
I_{11} & 0 & H_{x3} & H_{xy3} & 0 & 0 & H_{x3} & H_{xy4} \\
G_{11} & 0 & H_{yx3} & H_{y3} & 0 & 0 & H_{yx4} & H_{y4} \\
\hline
H_{x1} & H_{xy1} & I_{21} & 0 & H_{x2} & H_{xy2} & 0 & 0 \\
H_{yx1} & H_{y1} & G_{21} & 0 & H_{yx2} & H_{y2} & 0 & 0
\end{array}
$$

4(x + y)

x

y

## FIG.3

[Fig. 4]

$M_C$

| $1i_1$ | $1i_2$ | $1p_1$ | $1p_2$ | $2i_1$ | $2i_2$ | $2p_1$ | $2p_2$ |
|---|---|---|---|---|---|---|---|

1B   2B

## FIG.4

[Fig. 5]

M

Séparation niveaux
de priorité ⟩⟩ 501

$M_p$

H → Codage ⟩⟩ 502

$M_c$

# FIG.5

[Fig. 6]

FIG.6

[Fig. 7]

FIG.7

[Fig. 8]

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3035286

**Littérature non-brevet citée dans la description**

- **RAHNAVARD N et al.** New results on unequal error protection using LDPC codes. *IEEE Communications letters*
- **RICCIUTELLI GIACOMO et al.** *LDPC coded modulation schemes with largely unequal error protection*
- **CHI-JEN WU.** *a new construction of UEP QC-LDPC codes*
- **KUMAR V et al.** *On unequal error protection LDPC codes based on Plotkin-type constructions*
- **C. POULLIAT ; D. DECLERCQ ; I. FIJALKOW.** Enhancement of Unequal Error Protection Properties of LDPC Codes. *EURASIP Journal on Wireless Communications and Networking,* 2007, vol. 2007, 9
- **P. PULINI et al.** Unequal Diversity LDPC Codes for Relay Channels. *IEEE Trans. On Wireless Communications,* 11 Novembre 2013, vol. 12
- **C. LAMY-BERGOT ; B. GADAT.** Embedding protection inside H.264/AVC and SVC streams. *EURASIP Journal on Wireless Communications and Networking,* 2010
- **C. POULLIAT.** Contribution à l'étude et à l'optimisation de systèmes à composantes itératives. *HdR,* 2011
- **J. J. BOUTROS ; A. GUILLEN I FABREGAS ; E. BIGLIERI ; G. ZEMOR.** Low-Density Parity-Check Codes for Nonergodic Block-Fading Channels. *IEEE Transactions on Information Theory,* Septembre 2010, vol. 56 (9), 4286-4300
- **RYAN, W. ; LIN, S.** Channel Codes: Classical and Modem. Cambridge University Press, 2009
- Analysis and Improvement of GNSS Navigation Message Demodulation Performance in Urban Environments. **MARION ROUDIER.** Theses. INP, Janvier 2015